(19) **Europäisches Patentamt**
**European Patent Office**
**Office européen des brevets**

(11) **EP 1 547 164 B1**

(12) **EUROPÄISCHE PATENTSCHRIFT**

(45) Veröffentlichungstag und Bekanntmachung des Hinweises auf die Patenterteilung:
**26.11.2008  Patentblatt 2008/48**

(21) Anmeldenummer: 03757682.4

(22) Anmeldetag: **23.09.2003**

(51) Int Cl.:
***H01L 33/00*** *(2006.01)*

(86) Internationale Anmeldenummer:
**PCT/DE2003/003157**

(87) Internationale Veröffentlichungsnummer:
**WO 2004/032248 (15.04.2004 Gazette 2004/16)**

(54) **STRAHLUNGSEMITTIERENDES HALBLEITERBAUELEMENT UND VERFAHREN ZU DESSEN HERSTELLUNG**

RADIATION-EMITTING SEMICONDUCTOR COMPONENT AND METHOD FOR THE PRODUCTION THEREOF

COMPOSANT SEMI-CONDUCTEUR EMETTEUR DE RAYONNEMENT ET SON PROCEDE DE PRODUCTION

(84) Benannte Vertragsstaaten:
**DE FR GB**

(30) Priorität: **30.09.2002  DE 10245634**
**19.11.2002  DE 10253911**

(43) Veröffentlichungstag der Anmeldung:
**29.06.2005  Patentblatt 2005/26**

(73) Patentinhaber: **OSRAM Opto Semiconductors GmbH**
**93055 Regensburg (DE)**

(72) Erfinder:
• **BAUR, Johannes**
**93164 Laaber (DE)**
• **EISERT, Dominik**
**93049 Regensburg (DE)**
• **FEHRER, Michael**
**93077 Bad Abbach (DE)**

• **HAHN, Berthold**
**93155 Hemau (DE)**
• **HÄRLE, Volker**
**93164 Laaber (DE)**

(74) Vertreter: **Epping - Hermann - Fischer Patentanwaltsgesellschaft mbH**
**Ridlerstraße 55**
**80339 München (DE)**

(56) Entgegenhaltungen:
EP-A- 0 905 797    EP-A- 1 345 276
WO-A-01/61764    WO-A-01/73859
WO-A-01/80322    WO-A-03/010817
WO-A-03/030271    WO-A2-02/061847
DE-A- 2 416 098    DE-A- 2 554 029
DE-A- 4 130 878    DE-A- 10 139 798
DE-A- 10 208 170    US-A- 5 744 828
US-A- 6 121 636

## Beschreibung

Die Erfindung betrifft ein strahlungsemittierendes Halbleiterbauelement, das ein strahlungsdurchlässiges Substrat aufweist, auf dessen Unterseite eine strahlungserzeugende Schicht angeordnet ist. Das Substrat weist geneigte Seitenflächen auf. Ferner betrifft die Erfindung ein Verfahren zur Herstellung des strahlungsemittierenden Halbleiterbauelements.

Aus der Druckschrift US 5,087,949 ist ein Bauelement der eingangs genannten Art bekannt, bei dem die strahlungserzeugende Schicht auf der Unterseite des Substrats nur eine sehr kleine laterale Ausdehnung aufweist, so daß die Strahlungsquelle für die Optimierung der Form des Substrats als Punktlichtquelle betrachtet wird. Dementsprechend ist das Substrat so geformt, daß das von der Lichtquelle von Innen auf die Grenzflächen des Substrats fallende Licht möglichst immer unter einem Winkel einfällt, der kleiner ist als der kritische Winkel für Totalreflexion. Dadurch wird erreicht, daß ein möglichst großer Teil des von der strahlungserzeugenden Schicht erzeugten Lichts durch das Substrat transmittiert wird. Die Optimierung der Formgebung des Substrats im Hinblick auf eine im wesentlichen punktförmige Lichtquelle auf dessen Unterseite führt dazu, daß ein solches Substrat nur schlecht geeignet ist für strahlungserzeugende Schichten, die eine großflächige Ausdehnung aufweisen.

Aus der Druckschrift US 5,187,547 ist ein Bauelement der eingangs genannten Art bekannt, bei dem auf der Unterseite eines strahlungsdurchlässigen Substrates eine großflächig aufgebrachte strahlungserzeugende Schicht angeordnet ist, wodurch die insgesamt erzeugte Lichtmenge gegenüber einer punktförmigen Lichtquelle deutlich erhöht ist. Die Form des Substrates ist dabei so gewählt, daß zwischen der Oberseite und der Unterseite eine durchgehende schräge Kante verläuft, aus der das Licht aus dem Innern des Substrats nach außen ausgekoppelt wird. Die durchgehend von oben nach unten abgeschrägte Seitenkante des Substrats hat den Nachteil, daß die Herstellung einer Vielzahl solcher Substrate aus einem Wafer, bestehend aus einem hierfür geeigneten Material, zu einer reduzierten Flächenausbeute des Wafers führt.

Die zwischen zwei Substraten befindlichen V-förmigen Einschnitte werden nämlich üblicherweise mit einer geeigneten Säge gesägt, welche beim Sägen des Substrats, zu einem nicht zu vernachlässigenden lateralen Materialabtrag führt, wodurch die nutzbare Fläche der Einzelsubstrate nachteilig sinkt. Darüber hinaus ist es ein Nachteil, mit einem V-förmigen Sägeblatt ein Substrat gänzlich zu durchsägen, da hierbei das Sägeblatt leicht beschädigt werden kann.

WO 0161764 A beschreibt ein strahlungsemittierendes Halbleiterbauelement mit einem strahlungsdurchlässigen Substrat, auf dessen Oberseite eine strahlungserzeugende Schicht angeordnet ist; bei dem das Substrat geneigte Seitenflächen aufweist; bei dem der Brechungsindex des Substrates grösser ist als der Brechungsindex der strahlungserzeugenden Schicht; bei dem die strahlungserzeugende Schicht die Substratoberseite bis auf einen äusseren Freirand, der eine endliche Breite aufweist, bedeckt; bei dem aus dem Brechungsindexunterschied und der endlichen Breite des äusseren Freirands ein unbeleuchteter Substratbereich resultiert; und bei dem das Substrat an ihrer Oberseite senkrechte Seitenflächen aufweist, an deren die geneigten Seitenflächen angrenzen.

Es ist daher Aufgabe der vorliegenden Erfindung, ein strahlungsemittierendes Halbleiterbauelement anzugeben, das mit einer hohen Flächenausbeute aus Wafern hergestellt werden kann und das für hohe Lichtleistungen geeignet ist.

Ferner ist es Aufgabe der Erfindung, ein Verfahren zur Herstellung des Bauelementes anzugeben.

Diese Aufgaben werden gelöst durch ein strahlungsemittierendes Halbleiterbauelement gemäß Patentanspruch 1 sowie durch ein Verfahren zu dessen Herstellung gemäß Patentanspruch 21. Vorteilhafte Ausgestaltungen der Erfindung sind den abhängigen Patentansprüchen zu entnehmen.

Es wird ein strahlungsemittierendes Halbleiterbauelement angegeben, das ein strahlungsdurchlässiges Substrat aufweist. Auf der Unterseite des Substrats ist eine strahlungserzeugende Schicht angeordnet. Dabei ist das Substrat wenigstens für die in der strahlungserzeugenden Schicht erzeugte Strahlung durchlässig. Ferner weist das Substrat geneigte Seitenflächen auf. Der Brechungsindex des Substrates ist größer als der Brechungsindex der strahlungserzeugenden Schicht. Dieses Verhältnis der Brechungsindizes gilt insbesondere bei der Wellenlänge der in der strahlungserzeugenden Schicht erzeugten Strahlung.

Aufgrund des Unterschiedes der Brechungsindizes resultiert ein unbeleuchteter Bereich im Substrat, in den von der strahlungserzeugenden Schicht keine Photonen direkt eingekoppelt werden. Dieser so entstehende tote Winkel resultiert daher, daß aufgrund der Brechungsgesetze das Licht nicht unter beliebigen Winkeln in das Substrat eingekoppelt werden kann, sondern daß es hierfür einen kleinsten Grenzwinkel gibt, der durch den Brechungsindexunterschied bestimmt wird.

Bei der Erfindungs dient bevorzugt die vom Substrat abgewandte Seite der strahlungserzeugenden Schicht zur Montage des Bauelements (Up-Side-Down-Montage). Zweckmäßigerweise ist hierzu eine entsprechende Montagefläche auf der vom Substrat abgewandten Seite der strahlungserzeugenden Schicht vorgesehen.

Im unbeleuchteten Bereich weist das Substrat zur Unterseite des Substats senkrechte Seitenflächen auf. Hierunter sind solche Seitenflächen zu verstehen, die mit den zur Verfügung stehenden Mitteln möglichst senkrecht zur Unterseite des Substrates ausgeführt werden können. Hierbei seien beispielhaft die Mittel Sägen des Substrats mittels eines geraden Sägeblatts oder auch Brechen des Substrats aus einem größeren Substrat zum Zwecke der Vereinzelung.

Ein solches Bauelement hat den Vorteil, daß es aufgrund der in einem Seitenbereich des Substrats befindlichen senkrechten Seitenflächen mit wesentlich weniger Flächenbedarf herstellbar ist. Aufgrund der senkrechten Seitenflächen, die auf der Unterseite des Substrats einen Sockel bilden, kann der Abschnitt des Substrats auf einen Teilbereich der Substratdicke begrenzt werden, was den lateralen Abtrag von Substratmaterial auf das benötigte Minimum reduziert. Die schrägen Seitenflächen werden nämlich zu einer optimalen Auskopplung des Lichts aus dem Inneren des Substrats benötigt. Da jedoch im Bereich des toten Winkels kein Licht aus dem Substrat ausgekoppelt werden muß, kann, ohne die Lichtauskopplung negativ zu beeinflussen, an dieser Stelle die äußere Form des Substrats hinsichtlich einer verbesserten Herstellbarkeit optimiert werden. Eine solche vereinfachte oder verbesserte Herstellbarkeit, die insbesondere eine verbesserte Flächenausbeute bei der Herstellung von mehreren Einzelsubstraten aus einem großen Substrat durch Vereinzeln bedeuten kann, kann dadurch gewährleistet werden, daß im Bereich der senkrechten Kanten das Substrat beispielsweise durch Brechen oder auch durch gerades Sägen vereinzelt werden kann.

Beim geraden Sägen hat man einen sehr viel geringeren lateralen Materialabtrag als beim Sägen der schrägen Kanten. Wird das Vereinzeln durch Brechen des Substrats an der Stelle der geraden Seitenkanten vorgenommen, so ist der laterale Materialabtrag und damit die Flächenausbeute auf dem großen Substrat weiter optimiert.

Es wird dementsprechend ein Verfahren zur Herstellung des Bauelements angegeben, wobei V-förmige Gräben in ein Substrat mittels einer geeignet geformten Säge eingesägt werden. Dabei wird jedoch darauf geachtet, daß eine Restdicke des Substrates durchgehend stehen bleibt. In einem nachfolgenden Schritt wird das Substrat zu kleineren Einzelsubstraten vereinzelt, und zwar entlang der V-förmigen Gräben.

Dieses Verfahren hat den Vorteil, daß durch eine Verringerung der Tiefe der V-förmigen Gräben im Vergleich zu den aus dem Stand der Technik bekannten Substratformen der laterale Materialabtrag sowie der Verschleiß bei den für das Sägen V-förmiger Gräben geeigneten Sägen deutlich reduziert werden kann.

Das Vereinzeln der Substrate kann beispielsweise mittels eines geraden Sägeblatts erfolgen, welches einen wesentlich geringeren Ausschuß als ein v-förmiges Sägeblatt hat.

Darüber hinaus kann das Vereinzeln der Substrate auch durch Brechen erfolgen, wodurch der Ausschuß noch weiter reduziert ist.

Die senkrechten Seitenflächen des Bauelementes bilden einen Sockel auf der Unterseite des Substrats, an dessen Oberseite die geneigten Seitenflächen angrenzen. Eine solche Formgebung des Substrats hat den Vorteil, daß durch den Sockel an der Unterseite des Substrats der gesamte unbeleuchtete Bereich des Substrats für die senkrechten Seitenflächen genutzt werden kann. Desweiteren hat eine solche Formgebung den Vorteil, daß die V-förmigen Vertiefungen zwischen zwei Einzelsubstraten von einer Seite her gesägt werden können und nachfolgend nur noch ein einziger Schritt zur Bearbeitung der Seitenfläche des Substrats notwendig ist. Die obere Grenze des unbeleuchteten Bereichs des Bauelements fällt mit der oberen Grenze des Sockels zusammen. Daraus resultiert der Vorteil, daß die gesamte Höhe des unbeleuchteten Bereichs für die Bildung des Sockels verwendet werden kann. Je höher der Sockel des Substrates ausgebildet ist, desto weniger tief muß der V-förmige Einschnitt zwischen zwei Einzelsubstraten erfolgen und desto vorteilhafter kann die Flächenausbeute auf einem großen Substrat gestaltet werden.

Die strahlungserzeugende Schicht bedeckt die Substratunterseite des Bauelements bis auf einen äußeren Freirand, der eine endliche Breite aufweist. Indem die strahlungserzeugende Schicht die Unterseite fast ganz bedeckt, ist gewährleistet, daß entsprechend viel Strom in die strahlungserzeugende Schicht aufgrund der vergrößerten Fläche eingekoppelt werden kann, was die Lichtausbeute der strahlungserzeugenden Schicht erhöht.

Indem die strahlungserzeugende Schicht nicht ganz bis an den Rand der Unterseite des Substrates reicht, kann erreicht werden, daß die strahlungserzeugende Schicht, welche sehr empfindlich auf mechanische Beschädigungen reagiert, da sie beispielsweise nur mit einer dünnen Siliziumnitridschicht abgedeckt ist, bei der Vereinzelung von Einzelsubstraten aus einem großen Wafer vor Beschädigung geschützt werden kann.

Desweiteren hat die Ausbildung eines Freirandes an der Unterseite des Substrates den Vorteil, daß sich durch die Wahl einer geeigneten Breite für diesen Freirand die geometrische Ausdehnung des unbeleuchteten Substratbereichs bestimmen läßt. Je kleiner die Ausdehnung der strahlungserzeugenden Schicht auf der Unterseite des Substrates ist, umso größer ist der unbeleuchtete Substratbereich, da dieser bestimmt wird durch den Grenzwinkel, welcher wiederum vom Brechungsindexunterschied abhängt, sowie durch den Bereich vom Rand der strahlungserzeugenden Schicht bis zum Rand des Substrats, über den der Winkel eine Aufweitung des unbeleuchteten Substratbereichs in Richtung auf den Substratrand hin bewirkt.

Bei einer anderen Ausführungsform des Bauelements weist die strahlungserzeugende Schicht abgeschrägte Kanten auf, die so gestaltet sind, daß lateral zum Substrat abgestrahltes, in der strahlungserzeugenden Schicht erzeugtes Licht in Richtung auf das Substrat reflektiert wird.

Durch die abgeschrägten Seitenkanten der strahlungserzeugenden Schicht ergibt sich eine vorteilhafte Umlenkung der erzeugten Strahlung in Richtung auf das Substrat. Dadurch kann vorteilhafterweise die Lichtausbeute des strahlungserzeugenden Bauelements erhöht werden.

Um für die Reflexion der Strahlung in die richtige Richtung zu sorgen, ist es vorteilhaft, wenn die abgeschrägten Seitenkanten der strahlungserzeugenden Schicht mit der Substratunterseite einen Winkel zwischen 20 und 70° einschließen. Vorzugsweise ist es vorteilhaft, einen Winkel zwischen 30 und 60° zu wählen. In dem genannten Winkelbereich ist es zudem möglich, einen geeigneten Winkel für Totalreflexion anzugeben. Dabei hängt dieser Winkel von dem Material ab, von dem die strahlungserzeugende Schicht umgeben ist. Je nach Brechungsindexunterschied zwischen der strahlungserzeugenden Schicht und deren Umgebung kann ein geeigneter Winkel für eine Totalreflexion des in der strahlungserzeugenden Schicht erzeugten Lichts an der abgeschrägten Seitenkante gewählt werden.

Darüber hinaus ist es auch möglich, die Totalreflexion durch ein optisch reflektierendes Material auf der abgeschrägten Seitenkante zu bewirken. Beispielsweise kann die abgeschrägte Seitenkante mit einer Schicht enthaltend Aluminium oder Silber bedeckt sein. Hierzu ist eine Passivierungsschicht zwischen dem Halbleiter und dem Metall erforderlich.

Bei einer anderen Ausführungsform des Bauelements, sind auf der Oberseite des Substrats Kontaktelemente angeordnet. Darüber hinaus ist das Substratmaterial so gewählt, daß die Querleitfähigkeit, also die Leitfähigkeit lateral zur Substratunterseite, zu einer kegelförmigen Erweiterung eines vom Kontaktelement in das Substrat eingekoppelten Stromes führt. Eine kegelförmige Erweiterung erhält man insbesondere aufgrund der anisotropen Leitfähigkeit des Substrats. Ein geeignetes Material für das Substrat ist beispielsweise Siliziumcarbid.

Ferner sind die Kontaktelemente so voneinander beabstandet, daß die Stromaufweitungskegel sich in einer Tiefe berühren, in der die gesamte Querschnittsfläche des Substrates bestromt ist. Dementsprechend sind die Kontaktelemente so anzuordnen, daß zum einen eine möglichst vollflächige Bestromung des Substrates bereits bei einer relativ geringen Tiefe der zu bestromenden Querschnittsfläche unterhalb der Substratoberfläche vorliegt. Zum anderen sollte diejenige Tiefe, bei der eine vollständige Bestromung der Substratsquerschnittsfläche vorliegt, genauso groß sein, wie diejenige Tiefe im Substrat, bei der die Stromaufweitungskegel einander berühren.

Für den Fall, daß die Stromaufweitungskegel der einzelnen Kontaktstege sich bereits in einer Tiefe überschneiden, wo noch nicht die gesamte Substratquerschnittsfläche bestromt ist, würde sich der Nachteil ergeben, daß mit einer vollständigen Bestromung des Substrats in einer relativ großen Tiefe eine hohe Vorwärtsspannung resultieren würde, was für die elektrischen Eigenschaften des Bauelements nachteilig wäre. Zwar könnte auch in diesem Fall eine großflächige Bestromung des Substrats in einer relativ geringen Tiefe unterhalb der Substratoberfläche erfolgen, dann jedoch müßte die Anzahl der Kontaktstege auf der Oberfläche des Substrats erhöht werden, was die Lichtausbeute aus der Oberfläche des Substrats nachteilig beeinflussen würde, da die Kontaktstege üblicherweise nicht vollständig transparent oder reflektierend sind.

In der Anordnung der Kontaktelemente auf der Oberfläche des Substrats ist eine eigenständige Erfindung zu sehen, die unabhängig von der Sockelbildung auf der Unterseite des Substrats oder von einer Kantenabschrägung der strahlungserzeugenden Schicht auf Bauelemente der eingangs genannten Art angewendet werden kann.

In einer Ausführungsform des Bauelements sind die Kontaktelemente in Form von Leiterbahnen ausgeführt, die entlang von ineinanderliegenden Quadraten verlaufen. Die Quadrate weisen äquidistant zueinander und parallel zueinanderliegende Kanten auf. Diese Form der Kontaktelemente hat den Vorteil, daß eine gleichmäßige Bestromung der gesamten Substratoberfläche stattfinden kann. Darüber hinaus ist die genannte Struktur fototechnisch leicht realisierbar.

In einer Weiterbildung dieser Ausführungsform des Bauelements können die Leiterbahnen entsprechend der zu bestromenden Substratoberfläche voneinander verschiedene Breiten aufweisen. Insbesondere ist es vorteilhaft, wenn die Leiterbahnen der inneren Quadrate schmäler sind als die Leiterbahnen der weiter außen liegenden Quadrate. Da die Leiterbahnen der weiter außen liegenden Quadrate auch die unter der Seitenanschrägung liegende Substratfläche bestromen müssen, muß durch diese Leiterbahnen auch eine größere Substratfläche bestromt werden. Um hier eine ausreichende Kontaktfläche zwischen den Leiterbahnen und dem Substrat zu gewährleisten, ist es vorteilhaft, die äußeren Leiterbahnen breiter auszuführen, als die inneren. Eine Verbreiterung der innen liegenden Leiterbahnen über das wegen der elektrischen Eigenschaften erforderliche Maß hinaus ist nicht vorteilhaft, da in diesem Fall die optischen Eigenschaften des Bauelements zu leiden hätten.

In einer Ausführungsform des Bauelements enthält das Substrat Siliziumcarbid. Siliziumcarbid hat als Substratmaterial den Vorteil, daß es eine gute elektrische Leitfähigkeit aufweist. Es hat ferner den Vorteil, daß es das Abscheiden von Galliumnitrid als Material für Halbleitelaser oder Leuchtdioden für blaues Licht ermöglicht.

Ferner ist es vorteilhaft, wenn das Substrat aus dem hexagonalen 6H-Siliziumcarbid Polytypen besteht. Hexagonales 6H-Siliziumcarbid hat die Eigenschaft, daß die elektrische Leitfähigkeit senkrecht zur kristallografischen c-Achse, dies ist die Achse, die senkrecht auf der Oberfläche des Substrats steht, ungefähr drei Mal so hoch wie parallel zu dieser ist. Daraus resultiert insbesondere der Vorteil, daß Stromaufweitungskegel entstehen, die eine gleichmäßige Bestromung des Substrats ermöglichen.

Eine gleichmäßige Bestromung des Substrats ist insbesondere von Vorteil, falls die strahlungserzeugende Schicht mit hohen Strömen beaufschlagt werden soll, mit dem Ziel, eine möglichst hohe Lichtmenge zu erzeugen.

Desweiteren ist es vorteilhaft, insbesondere in Kombination mit einem Substrat aus Siliziumcarbid, wenn die strahlungserzeugende Schicht Galliumnitrid enthält. Dabei ist das Material nicht auf Galliumnitrid beschränkt, sondern kann auch Abwandlungen von Galliumnitrid enthalten, insbesondere Halbleitermaterialien, die auf Galliumnitrid basieren. Hier kommen insbesondere in Betracht Galliumnitrid, Galliumaluminiumnitrid, Indiumgalliumnitrid sowie p- oder n-dotierte Varianten der genannten Materialien. Galliumnitrid und sowie die genannten Abwandlungen davon haben den Vorteil, daß sie die Realisierung von strahlungserzeugenden Schichten erlauben, welche in dem besonders attraktiven Wellenlängenbereich des blauen Lichtes abstrahlen.

Die vorliegende Erfindung betrifft insbesondere Halbleiterbauelemente, bei denen die Substratunterseite eine Breite B von wenigstens 300 μm aufweist.

Diese großflächigen Substrate haben den Vorteil, daß relativ viel Strom für die Bestromung der strahlungserzeugenden Schicht verwendet werden kann, da ausreichende Fläche und mithin ein ausreichend geringer ohmscher Widerstand erzielt werden kann.

Dadurch gelingt es, den Serienwiderstand und damit die Betriebsspannung bzw. die Effizienz des Bauteils zu optimieren.

Im folgenden wird die Erfindung anhand von Ausführungsbeispielen und den dazugehörigen Figuren näher erläutert. In den Figuren bezeichnen gleiche Bezugszeichen Elemente, die einander gleichen oder deren Funktionsweise einander gleicht.

Figur 1     zeigt beispielhaft ein Bauelement in einem schematischen Querschnitt.

Figur 2     zeigt beispielhaft eine Computersimulation betreffend die Auskoppeleffizienz von Bauelementen gemäß Figur 1.

Figur 3     zeigt die Anordnung von Kontaktelementen in einem schematischen Querschnitt.

Figur 4     zeigt die Anordnung von Leiterbahnen in einer Draufsicht auf die Oberseite des Substrats.

Figur 5     zeigt beispielhaft eine weitere Ausführungsform von Leiterbahnen in Draufsicht auf ein Substrat.

Figur 6     zeigt einen Ausschnitt aus Figur 1, wobei eine abgeschrägte Seitenkante der strahlungserzeugenden Schicht gezeigt ist.

Figur 7     zeigt ein Substrat während der Durchführung eines Verfahrens zur Herstellung des Bauelements.

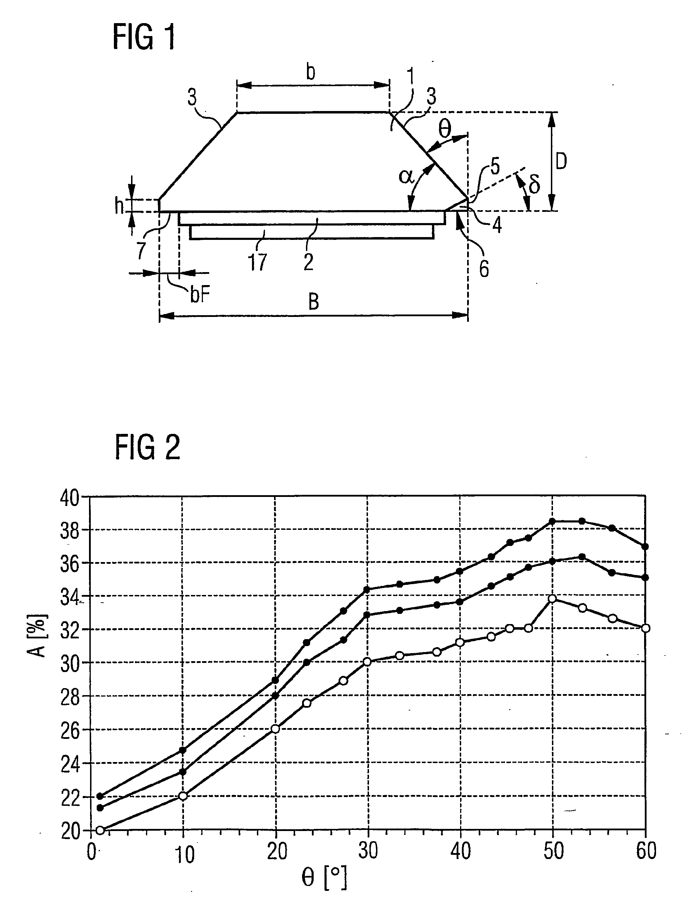

Figur 1 zeigt ein Substrat 1, das auf der Unterseite von einer strahlungserzeugenden Schicht 2 bedeckt ist. Das Substrat 1 weist auf der Unterseite eine Breite B auf. Ferner weist das Substrat 1 auf der Oberseite eine verminderte Breite b auf. Ferner weist das Substart 1 geneigte Seitenflächen 3 auf. Es ist besonders vorteilhaft, wenn die Breite B der Substratunterseite einen Wert zwischen 300 und 2000 μm aufweist. Für die weiteren Betrachtungen soll eine Substratbreite B von 1000 μm zugrundegelegt werden. Die geneigten Seitenflächen 3 schließen mit der Substratunterseite einen Winkel α ein; komplementär dazu ist der Winkel θ eingezeichnet, den die geneigten Substratflächen mit der Substratnormalen (gestrichelt gezeichnet) einschließen und welche in Figur 2 aufgetragen ist, wo die Auskoppeleffizienz diskutiert wird. Auf der Unterseite der strahlungserzeugenden Schicht 2 ist eine Kontaktschicht 17 aufgebracht, welche im Falle von Galliumnitrid als Basismaterial für die strahlungserzeugende Schicht 2 ein p-Spiegelkontakt sein kann. Dies bedeutet, daß die Unterseite der strahlungserzeugenden Schicht 2 dem positiven elektrischen Kontakt zugeordnet ist. Der p-Spiegelkontakt erfüllt dabei zwei Funktionen. Zum einen sorgt er für eine großflächige, niederohmige Kontaktierung der strahlungserzeugenden Schicht 2. Zum anderen hat diese Kontaktschicht 17 auch reflektierende Eigenschaften, d.h., daß das in der strahlungserzeugenden Schicht 2 erzeugte Licht von der Kontaktschicht 17 reflektiert wird und mithin durch das Substrat 1 aus dem Bauelement ausgekoppelt werden kann.

Wie der Figur 1 zu entnehmen ist, ist die strahlungserzeugende Schicht 2 nicht ganzflächig auf der Unterseite des Substrats 1 aufgebracht, sondern es ist ein Freirand 7 vorhanden. Der Freirand 7 ist von der strahlungserzeugenden Schicht 2 unbedeckt. Es soll im weiteren davon ausgegangen werden, daß das Material des Substrates 1 hexagonales Siliziumcarbid ist. Es kommen aber auch andere geeignete Materialien in Betracht. Es soll ferner davon ausgegangen werden, daß das Material der strahlungserzeugenden Schicht 2 Galliumnitrid bzw. ein auf Galliumnitrid basierendes Halbleitermaterial ist, welches zur Herstellung im blauen Spektralbereich emittierenden Leuchtdioden bzw. bei Halbleiterlasern geeignet ist.

Für die Brechungsindizes dieser Materialien gilt, daß der Brechungsindex von Siliziumcarbid n1 = 2,7 und im Vergleich dazu der Brechungsindex von Galliumnitrid n2 = 2,5 ist. Dementsprechend ist der Brechungsindex des Substrates 1 größer als der Brechungsindex der strahlungserzeugenden Schicht 2. Dieser Brechungsindexunterschied führt dazu, daß es Bereiche im Substrat 1 gibt, die nicht von Licht aus der strahlungserzeugenden Schicht 2 beleuchtet sind. Diese unbeleuchteten Substratbereiche 4 resultieren aus den strahlenoptischen Gesetzen, die bestimmen, unter welchem Winkel bei unterschiedlichem Brechungsindex Strahlung von dem einen Material in das andere Material gelangen kann. Im vorliegenden Fall ergibt sich ein sogenannter "toter Winkel", der mit δ bemaßt ist. Bei den hier beispielhaft genannten Materialien beträgt der tote Winkel δ ungefähr 22,2°.

Ausgehend vom äußersten Rand der strahlungserzeugenden Schicht 2 ergibt sich so ein keilförmiger, unbeleuchteter Substratbereich 4, welcher durch die Substratunterseite sowie im Querschnitt durch den Winkel δ begrenzt wird. Es ist klar zu erkennen, daß der unbeleuchtete Substratbereich 4 in seiner Ausdehnung davon abhängig ist, wie groß der Freirand 7 am Rand der strahlungserzeugenden Schicht 2 ist. Darüber hinaus hängt die Ausdehnung des unbeleuchteten Substratbereichs 4 auch vom Brechungsindexunterschied zwischen dem Substrat 1 und der strahlungserzeugenden Schicht 2 ab. An der Unterseite des Substrats 1, im Bereich des unbeleuchteten Substratbereichs 4 weist das Substrat einen Sockel 6 auf, in dessen Bereich die Seitenflächen 5 des Substrats 1 im wesentlichen senkrecht auf der Unterseite des Substrates 1 stehen.

Im Bereich des Sockels 6 weist das Substrat 1 im wesentlichen senkrechte Seitenflächen 5 auf, welche die Herstellung des Substrats 1 vereinfachen und die Ausbeute an Substratfläche verbessern. In dem in Figur 1 gezeigten Beispiel weist der Sockel 6 eine Höhe h von etwa 20 μm auf. Die Breite des Freirandes bF beträgt ca. 25 μm. Dieses ist ein geeignetes Maß, um einerseits die strahlungserzeugende Schicht 2 beim Vereinzeln des Substrats 1 aus einem Wafer heraus zu schützen. Andererseits ist dieses Maß klein genug, um eine möglichst großflächige Belegung der Unterseite des Substrats 1 mit strahlungserzeugender Schicht 2 und damit günstige elektrische Eigenschaften des Bauelementes zu gewährleisten. Darüber hinaus sei noch auf die Dicke D des Substrats hingewiesen, welche 250 μm beträgt.

Die in Figur 1 gezeigte Anordnung ist besonders für eine gute Auskopplung von Licht aus der strahlungserzeugenden Schicht 2 geeignet, da Photonen, die von der strahlungserzeugenden Schicht 2 nach unten abgestrahlt werden, durch die Kontaktschicht 17 reflektiert und über das Substrat 1 ausgekoppelt werden können. Darüber hinaus werden diejenigen Photonen, die von der strahlungserzeugenden Schicht 2 nach oben hin emittiert werden, direkt in das Substrat 1 und von dort nach außen ausgekoppelt.

Figur 2 zeigt die Ergebnisse einer "Ray-Tracer"-Simulation, wobei die Auskoppeleffizienz A, gemessen in der Einheit % über dem Winkel θ, gemessen in °, aufgetragen ist. Dabei gibt es drei verschiedene Meßkurven, wobei die erste Meßkurve durch Rauten, die zweite Meßkurve durch Quadrate und die dritte Meßkurve durch Kreise repräsentiert sind. Die erste Meßkurve mit den Rauten gehört zu einer Breite B von 900 μm.

Die zweite Kurve mit den Quadraten gehört zu einer Breite B von 1000 μm. Die dritte Kurve mit den Kreisen gehört zu einer Breite B von 1200 μm. Gemäß Figur 2 wird eine optimale Auskopplung des Lichts für einen Winkel θ von 50° erreicht. Allerdings kann bei der Wahl eines solchen Winkels je nachdem, wie groß das Substrat 1 ist, die verbleibende Oberfläche b sehr gering werden, was zu einem ungünstigen Serienwiderstand führen würde. Aus einem erhöhten Serienwiderstand würden zusätzliche Leistungsverluste den Effizienzgewinn aufgrund der Auskopplung überkompensieren. Dementsprechend sollen die hier vorliegenden Beschreibung eines Halbleiterbauelements ein Winkel θ angegeben werden, der bei einer Breite B von 1000 μm und einer Substratdicke von 250 μm im Bereich zwischen 30° und 45° liegt. Indem berücksichtigt wird, daß gilt:

$$\alpha + \theta = 90°$$

können die beiden Winkel α und θ, die hier nebeneinander benutzt werden, jederzeit ineinander umgerechnet werden.

Ein weiterer Vorteil der in Figur 1 gezeigten "Up-Side-Down"-Montage, d.h. der Montage der strahlungserzeugenden Schicht über Kopf, liegt in der im Vergleich zu der standardmäßig verwendeten "Up-Side-Up"-Montage in der nach vorne gerichteten Emissionscharakteristik, die eine günstigere Lichtauskopplung aus einem den das Substrat 1 umgebenden Gehäuse erlaubt.

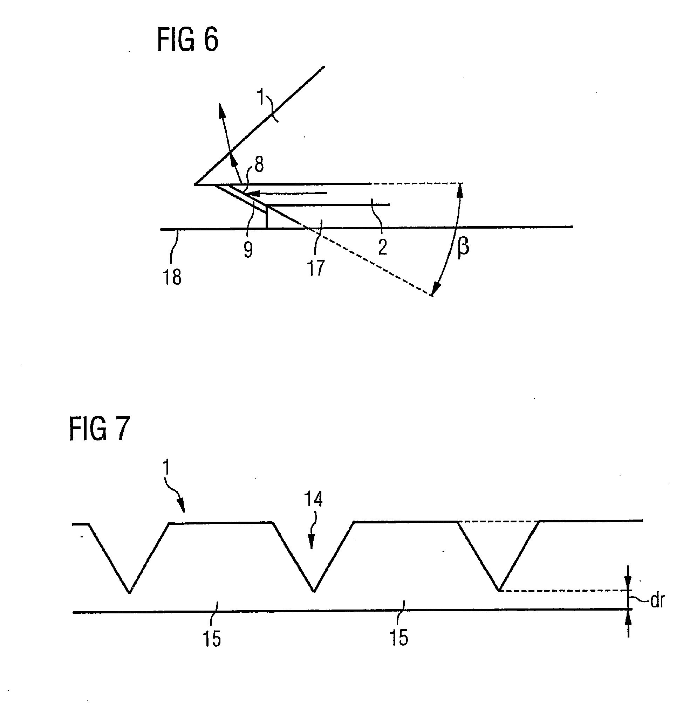

Hierzu wird noch auf Figur 6 verwiesen, aus der hervorgeht, daß das Substrat 1 mit der Unterseite bzw. mit der Kontaktschicht 17 auf einem Leiterrahmen 18 montiert sein kann, und woraus auch hervorgeht, daß im wesentlichen die Oberseite des Substrats 1 zur Lichtauskopplung verwendet wird.

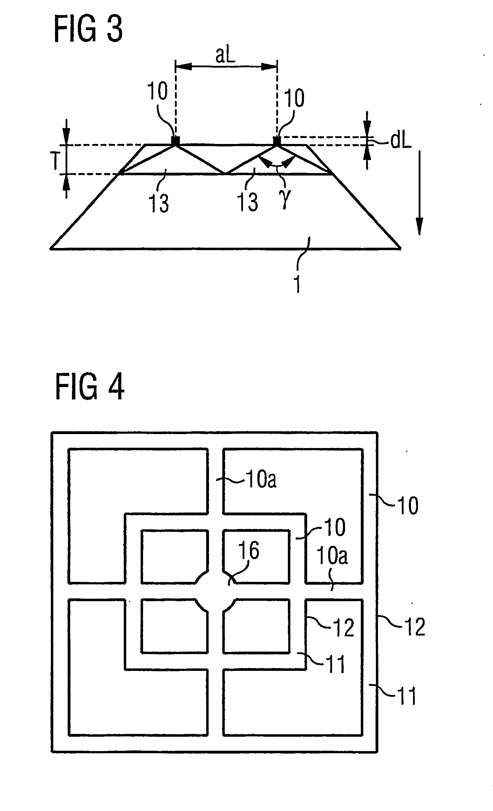

Figur 3 zeigt das Prinzip für die Anordnung von Leiterbahnen 10, die zu einer wesentlichen Reduktion des Serienwiderstands des Bauelementes und zu einer hohen Lichttransmission durch die Substratoberfläche hindurch beitragen kann. Eine geeignete Kontaktierung besteht darin, daß beispielsweise Leiterbahnen 10 auf der Oberseite des Substrats 1 angeordnet sind. Aufgrund der senkrecht zur kristallografischen c-Achse (angedeutet durch den senkrechten Pfeil nach unten) vorhandenen Leitfähigkeit und parallel zu dieser besseren, kommt es zu einer nicht isotropen Leitfähigkeit des Substrates 1. Daraus resultiert eine Aufweitung des durch die Leiterbahn 10 in das Substrat 1 eingekoppelten elektrischen Stromes, so daß sog. Stromaufweitungskegel 13 resultieren, die in Figur 3 dargestellt sind, und die aufzeigen, wie die Aufweitung des Stromes aufgrund der lateralen Leitfähigkeit dese Substrates 1 vonstatten geht. Für das hier betrachtete Beispiel von einem Substrat 1 aus hexagonalem Siliziumcarbid ergibt sich Öffnungswinkel γ des Stromaufweitungskegels 13 von 140°. Der Abstand aL der Leiterbahnen 10 voneinander wird nun idealerweise so gewählt, daß in einer Tiefe T des Substrats 1 gleichzeitig folgende Bedingungen eintreten:

　　1. Die gesamte Querschnittsfläche des Substrates 1 ist bestromt, d.h., daß jeder Flächenabschnitt der Querschnittsfläche in der Tiefe T des Substrates 1 wenigstens in einem Stromaufweitungskegel 13 liegt.

2. In der Tiefe T überlappen benachbarte Stromaufweitungskegel 13 erstmals miteinander.

Die hier genannten Bedingungen ergeben ein Optimum für die Positionierung der Leiterbahnen 10, da einerseits eine optimale Bestromung des Substrates 1 und andererseits eine minimale Bedeckung der Fläche des Substrates 1 und mithin gute optische Eigenschaften des Bauelementes resultieren. In dem in Figur 1 gezeigten Beispiel kann der Abstand der beiden Leiterbahnen aL 50 $\mu$m betragen. Die Dicke dL der Leiterbahnen 10 kann typischerweise 1 bis 1,5 $\mu$m betragen, wobei hier Maße angegeben werden, die üblicherweise bei der hier verwendeten Strukturierungsmethode standardmäßig vorkommen. Die Leiterbahnen 10 können auch jedes andere geeignete Dickenmaß aufweisen. Die Leiterbahnen 10 können aus jedem geeigneten elektrisch leitenden Material, beispielsweise aus Aluminium oder Silber bestehen.

Figur 4 zeigt in Draufsicht eine Anordnung von Leiterbahnen 10, wie sie für die Kontaktierung der Oberseite des Substrates 1, welche in dem genannten Beispiel der n-Kontakt wäre, ausgeführt werden kann. Die Leiterbahnen 10 sind in der Form von Quadraten 11 angeordnet. Die Quadrate 11 weisen Seitenkanten 12 auf, wobei entsprechende Seitenkanten 12 der Quadrate 11 zueinander parallel sind. Es ergibt sich daraus eine Anordnung der Quadrate 11 ineinander, die analog zu konzentrischen Kreisen betrachtet werden kann. In der Mitte der Quadrate 11 ist eine Lötfläche 16 angeordnet, die dafür geeignet ist, mit einem Bonddraht elektrisch kontaktiert zu werden. Desweiteren sind kreuzförmig angeordnete Verbindungs-Leiterbahnen 10a vorgesehen, die für die elektrische Kontaktierung der Leiterbahnen 10 mit der Lötfläche 16 sorgen. Somit kann durch Kontaktieren der Lötfläche 16 jede der Leiterbahnen 10 elektrisch kontaktiert werden. Mithin kann auch die Oberseite des Substrates 1 großflächig kontaktiert werden.

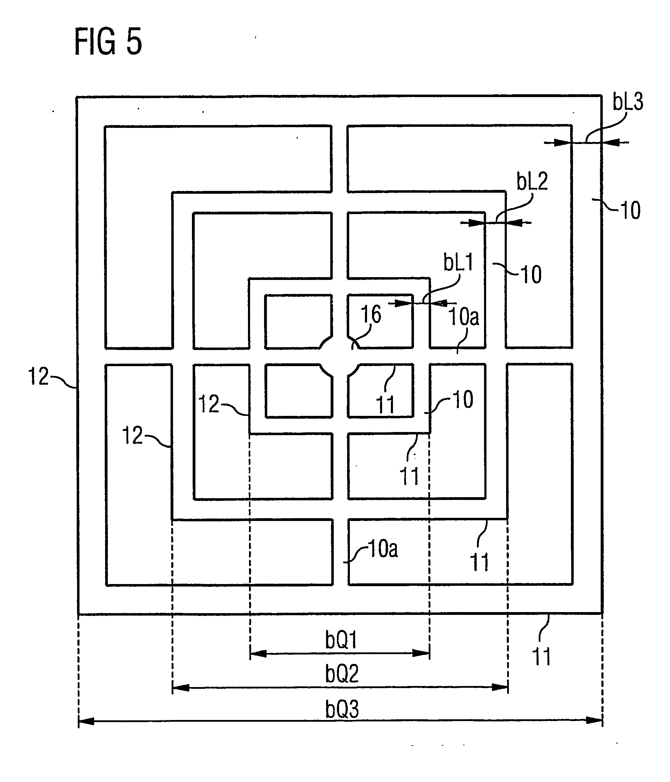

Figur 5 zeigt eine weitere Ausführungsform für eine Kontaktierungsstruktur für die Oberseite des Substrates 1. Gemäß Figur 5 sind die Leiterbahnen 10 entlang von drei Quadraten 11 angeordnet. Jedes dieser Quadrate 11 hat eine unterschiedliche Breite, wobei die Seitenkanten 12 der Quadrate 11 zueinander äquidistant angeordnet sein können. Dies wäre beispielsweise realisierbar, indem für die Breiten bQ1 bQ2, bQ3 der Quadrate 11 folgende Bemaßung gilt:

bQ1 = 220 $\mu$m
bQ2 = 440 $\mu$m
bQ3 = 660 $\mu$m.

Durch die äquidistante Anordnung der Quadrate 11 kann eine homogene Bestromung der Oberseite des Substrates 1 erreicht werden.

In Figur 5 ist als weiterer Aspekt noch gezeigt, daß die Breite der Leiterbahnen 10 mit zunehmender Quadratfläche ansteigt. Dementsprechend beträgt die Breite der innersten Leiterbahn bL1 16 $\mu$m, die Breite bL2 der mittleren Leiterbahn 10 20 $\mu$m und die Breite bL3 der äußeren Leiterbahn 10 27 $\mu$m. Die Maße der Breiten bL1, bL2, bL3 der Leiterbahnen 10 sind so gewählt, daß sie in etwa proportional zu der von der entsprechenden Leiterbahn 10 zu bestromenden Fläche ansteigen.

Die Dicke der in Figur 3 gezeigten Leiterbahnen 10 wird im wesentlichen bestimmt durch die Schichtdicke der in der Mitte der Quadrate 11 angeordneten Lötfläche 16, welche eine bestimmte Mindestdicke aufweisen muß, um eine zuverlässige Lötung zu gewährleisten. Da es vorteilhaft ist, die Leiterbahnen 10, die Verbindungs-Leiterbahnen 10a und die Lötfläche 16 in einem einzigen Prozeß- bzw. Maskenschritt auf die Oberseite des Substrates 1 aufzubringen, ist es ebenso vorteilhaft, die Leiterbahnen 10, die Verbindungs-Leiterbahnen 10a sowie die Lötfläche 16 in der gleichen Schichtdicke herzustellen. In einem anderen möglichen Prozeß könnte es auch vorteilhaft sein, die Lötfläche 16 dicker auszuführen als die Leiterbahnen 10 bzw. die Verbindungsleiterbahnen 10a, da auf den Leiterbahnen 10, 10a nicht gebondet wird und diese mithin auch dünner ausgeführt werden können, um beispielsweise Material einzusparen.

Figur 6 zeigt ein Substrat 1, auf dessen Unterseite eine strahlungserzeugende Schicht 2 aufgebracht ist. Auf der Unterseite der strahlungserzeugenden Schicht 2 ist darüber hinaus eine elektrische Kontaktschicht 17 aufgebracht. Die strahlungserzeugende Schicht 2 weist eine abgeschrägte Seitenkante 8 auf, die dazu geeignet ist, Licht, welches in der strahlungserzeugenden Schicht 2 erzeugt wird, in das Substrat 1 und von dort nach oben in die gewünschte Richtung zu reflektieren und somit die Lichtausbeute des Bauelementes weiter in vorteilhafter Weise zu erhöhen. Für die Reflexion an der abgeschrägten Seitenkante 8 kann es vorteilhaft sein, je nachdem, wie der Brechungsindexunterschied zwischen der strahlungserzeugenden Schicht 2 und dem umgebenden Medium ist, eine Totalreflexion an dieser Seitenkante auszunutzen. Es ist aber auch möglich, unabhängig von der Totalreflexion ein reflektierendes Material 9 auf die abgeschrägte Seitenkante 8 zu bringen, und dadurch die Reflexion der Strahlung in die gewünschte Richtung zu bewirken. Um einen elektrischen Kurzschluß zwischen dem Substrat 1 und der Kontaktschicht 17 zu verhindern, ist es gegebenenfalls noch sehr zweckmäßig, zwischen dem reflektierenden Material 9, welches vorteilhafterweise Silber oder Aluminium ist, eine elektrische Isolierschicht aufzubringen. Diese Isolierschicht kann beispielsweise Siliziumnitrid sein.

In dem hier gezeigten Ausführungsbeispiel ist es vorteilhaft, den Winkel $\beta$, den die abgeschrägte Seitenkante 8 mit der Unterseite des Substrats 1 einschließt zwischen 30 und 60° zu wählen.

Figur 7 zeigt ein Substrat 1 während der Herstellung einer Vielzahl von Einzelsubstraten 15, welche wiederum die Grundlage für ein Substrat 1 gemäß Figur 1 bilden. Es werden in das große Substrat 1 V-förmige Gräben 14 geschnitten, wobei vorteilhafterweise ein V-förmiges Sägeblatt zum Einsatz kommt. Jedoch wird das große Substrat 1 nicht ganz durchsägt, sondern es bleibt vielmehr eine Restdicke dr des Substrates stehen. Diese Restdicke dr kann dem Beispiel von Figur 1 folgend beispielsweise 20 $\mu$m betragen. Anschließend können die Einzelsubstrate 15 durch Brechen oder durch gerades Sägen vereinzelt werden.

Die gemäß der Figuren beschriebenen Ausführungsformen des Bauelementes beschränken nicht die hier dargestellte Erfindung, vielmehr kann die Erfindung mit allen geeigneten Materialien, die die genannten Bedingungen erfüllen, ausgeführt werden.

**Patentansprüche**

1. Strahlungsemittierendes Halbleiterbauelement

   - mit einem strahlungsdurchlässigen Substrat (1), auf dessen Unterseite eine strählungserzeugende Schicht (2) angeordnet ist,
   - bei dem das Substrat (1) geneigte Seitenflächen (3) aufweist,
   - bei dem der Brechungsindex des Substrates (n1) größer ist als der Brechungsindex (n2) der strahlungserzeugenden Schicht (2),
   - bei dem die strahlungsemittierende Schicht die Unterseite des Substrats bis auf einen äußeren Freirand (7), der eine endliche Breite (bF) aufweist, bedeckt,
   - bei dem aus dem Brechungsindexunterschied und der endlichen Breite des äußeren Freirands ein unbeleuchteter Substratbereich (4) resultiert, in den keine Photonen unmittelbar aus der strahlungserzeugenden Schicht (2) eingekoppelt werden,
   - bie dem das Substrat (1) im unbeleuchteten Bereich (4) zur Unterseite des Substrats senkrechte Seitenflächen (5) aufweist,
   - bei dem die senkrechten Seitenflächen (5) einen Sockel (6) auf der Substratunterseite bilden, an dessen Oberseite die geneigten Seitenflächen (3) angrenzen, **dadurch gekennzeichnet, daß**
   - die obere Grenze des unbeleuchteten Bereichs (4) mit der oberen Grenze (h) des Sockels (6) zusammenfällt.

2. Bauelement nach Anspruch 1,
   **dadurch gekennzeichnet, daß**
   die von dem Substrat (1) abgewandte Seite der strahlungserzeugenden Schicht (2) zur Montage des Bauelements vorgesehen ist.

3. Bauelement nach Anspruch 2,
   **dadurch gekennzeichnet, daß**
   auf der von dem Substrat (1) abgewandten Seite der strahlungserzeugenden Schicht (2) eine reflektierende elektrische Kontaktschicht (17) ausgebildet ist.

4. Bauelement nach einem der vorherigen Ansprüche,
   **dadurch gekennzeichnet, daß**
   die Höhe (h) des Sockels (6) zwischen 15 und 30 $\mu$m beträgt.

5. Bauelement nach einem der Ansprüche 1 bis 4,
   **dadurch gekennzeichnet, daß**
   die geneigten Seitenflächen (3) einen Winkel ($\alpha$) zwischen 15 und 40° mit der Substratunterseite bilden.

6. Bauelement nach einem der Ansprüche 1 bis 5,
   **dadurch gekennzeichnet, daß**
   das Substrat (1) auf der Unterseite eine Breite (B) zwischen 300 und 2000 $\mu$m aufweist.

7. Bauelement nach einem der Ansprüche 1 bis 6,
   **dadurch gekennzeichnet, daß**
   das Substrat (1) eine Dicke (D) aufweist, die zwischen 200 und 300 $\mu$m liegt.

8. Bauelement nach einem der Ansprüche 1 bis 7,
   **dadurch gekennzeichnet, daß**
   die strahlungserzeugende Schicht (2) die Substratunterseite bis auf einen äußeren Freirand (7) mit einer Breite (bF) zwischen 10 und 50 $\mu$m bedeckt.

9. Bauelement nach einem der Ansprüche 1 bis 8,
   **dadurch gekennzeichnet, daß**
   die strahlungserzeugende Schicht (2) abgeschrägte Seitenkanten (8) aufweist, die das lateral zum Substrat (1) abgestrahlte Licht in Richtung auf das Substrat (1) reflektieren.

10. Bauelement nach Anspruch 9,
    **dadurch gekennzeichnet, daß**
    die abgeschrägten Seitenkanten (8) mit der Substratunterseite einen Winkel ($\beta$) zwischen 20 und 70° einschließen.

11. Bauelement nach einem der Ansprüche 9 oder 10,
    **dadurch gekennzeichnet, daß** die abgeschrägten Kanten (8) der strahlungserzeugenden Schicht (2) mit dem Substrat (1) einen Winkel ($\beta$) einschließen, der für eine Totalreflexion der Strahlung an den Seitenkanten (8) geeignet ist.

12. Bauelement nach einem der Ansprüche 9 bis 11,
    **dadurch gekennzeichnet, daß** die Seitenkanten (8) der strahlungserzeugenden Schicht (2) mit einem optisch reflektierenden Material (9) abgedeckt sind.

13. Bauelement nach Anspruch 12,
    **dadurch gekennzeichnet, daß** das optisch reflektierende Material (9) Aluminium oder Silber ist.

14. Bauelement nach einem der Ansprüche 1 bis 13,
    **dadurch gekennzeichnet, daß**

    - auf der Oberseite des Substrats (1) elektrische Kontaktelemente (10, 10a) angeordnet sind,
    - die Querleitfähigkeit des Substrats (1) zu einer kegelförmigen Erweiterung eines vom Kontaktelement (10) in das Substrat (1) eingekoppelten Stromes führt, und
    - die Kontaktelemente (10) so voneinander beabstandet sind, daß die Stromaufweitungskegel (13) sich in einer Tiefe (T) berühren, in der die gesamte Querschnittsfläche des Substrates (1) bestromt ist.

15. Bauelement nach Anspruch 14,
    **dadurch gekennzeichnet, daß**
    die elektrischen Kontaktelemente Leiterbahnen (10) sind, die entlang von ineinanderliegenden Quadraten (11) verlaufen, wobei die Quadrate (11) äquidistante, zueinander parallele Seitenkanten (12) aufweisen.

16. Bauelement nach Anspruch 15,
    **dadurch gekennzeichnet, daß** die Leiterbahnen (10) entsprechend der zu bestromenden Oberfläche des Substrats (1) voneinander verschiedene Breiten (bL1, bL2, bL3) aufweisen.

17. Bauelement nach einem der Ansprüche 1 bis 16,
    **dadurch gekennzeichnet, daß** das Substrat (1) Siliziumcarbid enthält.

18. Bauelement nach einem der Ansprüche 1 bis 17,
    **dadurch gekennzeichnet, daß** das Substrat (1) hexagonales 6H-Siliziumcarbid enthält.

19. Bauelement nach einem der Ansprüche 1 bis 18,
    **dadurch gekennzeichnet, daß**
    die strahlungserzeugende Schicht (2) Galliumnitrid enthält.

20. Bauelement nach einem der Ansprüche 1 bis 19,
    **dadurch gekennzeichnet, daß**
    die Substratunterseite eine Breite (B) von wenigstens 300 $\mu$m aufweist.

21. Verfahren zur Herstellung eines strahlungsemittierenden Halbleiterbauelements nach einem der vorhergehenden Ansprüche, mit folgenden Schritten:

    - Anordnen einer strahlungserzeugenden Schicht (2) auf einer Unterseite eines strahlungsdurchlässigen Substrats (1),

    wobei der Brechungsindex des Substrates (n1) größer ist als der Brechungsindex (n2) der strahlungserzeugenden Schicht (2),

    - Einsägen von V-förmigen Gräben (14) in das strahlungsdurchlässige Substrat (1) mittels einer geeignet geformten Säge, wobei eine Restdicke (dr) des Substrats (1) durchgehend stehen bleibt und geneigte Seitenflächen (3) erzeugt werden,
    - Vereinzeln des Substrats (1) in eine Vielzahl von Einzelsubstraten (15) entlang der Gräben (14),

    wobei im Bereich der Restdicke (dr) des Substrats (1) zur Unterseite des Substrats senkrechte Seitenflächen (5) erzeugt werden und,

    - die strahlungsemittierende Schicht (2) nach dem Vereinzeln die Unterseite des Substrats bis auf einen äußeren Freirand, der eine endliche Breite (bF) aufweist, bedeckt,
    - aus dem Brechungsindexunterschied und der endlichen Breite des äußeren Freirands ein unbeleuchteter Substratbereich (4) resultiert, in den im Betrieb des strahlungsemittierenden Halbleiterbauelements keine Photonen unmittelbar aus der strahlungserzeugenden Schicht (2) eingekoppelt werden,
    - die senkrechten Seitenflächen (5) einen Sockel (6) auf der Substratunterseite bilden, an dessen Oberseite die geneigten Seitenflächen (3) angrenzen, und
    - die obere Grenze des unbeleuchteten Bereichs (4) mit der oberen Grenze des Sockels (6) zusammenfällt.

22. Verfahren nach Anspruch 21,
    **dadurch gekennzeichnet, daß**
    das Vereinzeln durch eine Säge mit einem geraden Sägeblatt erfolgt.

23. Verfahren nach Anspruch 21,
    **dadurch gekennzeichnet, daß**
    das Vereinzeln durch Brechen erfolgt.

## Claims

1. Radiation-emitting semiconductor component

    - having a radiation-transmissive substrate (1), on the underside of which a radiation-generating layer (2) is arranged,
    - in which the substrate (1) has inclined side areas (3),

- in which the refractive index of the substrate (n1) is greater than the refractive index (n2) of the radiation-generating layer (2),

- in which the radiation-emitting layer covers the underside of the substrate apart from an outer free edge (7), which has a finite width (bF),

- in which the difference in refractive index and the finite width of the outer free edge result in an unilluminated substrate region (4), into which no photons are coupled directly from the radiation-generating layer (2),

- in which the substrate (1) has side areas (5) perpendicular to the underside of the substrate in the unilluminated region (4),

- in which the perpendicular side areas (5) form a base (6) on the underside of the substrate, the inclined side areas (3) adjoining the top side of said base,

**characterized in that**

- the upper boundary of the unilluminated region (4) coincides with the upper boundary (h) of the base (6).

2. Component according to Claim 1,
**characterized in that**
the side of the radiation-generating layer (2) which is remote from the substrate (1) is provided for the mounting of the component.

3. Component according to Claim 2,
**characterized in that**
a reflective electrical contact layer (17) is formed on the side of the radiation-generating layer (2) which is remote from the substrate (1).

4. Component according to one of the preceding claims,
**characterized in that**
the height (h) of the base (6) is between 15 and 30 $\mu$m.

5. Component according to one of Claims 1 to 4,
**characterized in that**
the inclined side areas (3) form an angle ($\alpha$) of between 15 and 40° with the underside of the substrate.

6. Component according to one of Claims 1 to 5,
**characterized in that**
the substrate (1) has a width (B) of between 300 and 2000 $\mu$m on the underside.

7. Component according to one of Claims 1 to 6,
**characterized in that**
the substrate (1) has a thickness (D) of between 200 and 300 $\mu$m.

8. Component according to one of Claims 1 to 7,
**characterized in that**
the radiation-generating layer (2) covers the underside of the substrate apart from an outer free edge (7) having a width (bF) of between 10 and 50 $\mu$m.

9. Component according to one of Claims 1 to 8,
**characterized in that**
the radiation-generating layer (2) has bevelled side edges (8), which reflect the light emitted laterally with respect to the substrate (1) in the direction of the substrate (1).

10. Component according to Claim 9,
**characterized in that**
the bevelled side edges (8) form an angle ($\beta$) of between 20 and 70° with the underside of the substrate.

11. Component according to either of Claims 9 and 10,
**characterized in that**
the bevelled edges (8) of the radiation-generating layer (2) form with the substrate (1) an angle ($\beta$) suitable for a total reflection of the radiation at the side edges (8).

12. Component according to one of Claims 9 to 11,
**characterized in that**
the side edges (8) of the radiation-generating layer (2) are covered with an optically reflective material (9).

13. Component according to Claim 12,
**characterized in that**
the optically reflective material (9) is aluminum or silver.

14. Component according to one of Claims 1 to 13,
**characterized in that**

- electrical contact elements (10, 10a) are arranged on the top side of the substrate (1),
- the transverse conductivity of the substrate (1) leads to a conical extension of a current coupled into the substrate (1) from the contact element (10), and
- the contact elements (10) are spaced apart from one another in such a way that the current expansion cones (13) touch one another at a depth (T) at which the entire cross-sectional area of the substrate (1) is energized.

15. Component according to Claim 14,
**characterized in that**
the electrical contact elements are interconnects (10) running along nested squares (11), the squares (11) having equidistant side edges (12) parallel to one another.

**16.** Component according to Claim 15, **characterized in that** the interconnects (10) have widths (bL1, bL2, bL3) that differ from one another in accordance with the surface of the substrate (1) that is to be energized.

**17.** Component according to one of Claims 1 to 16, **characterized in that** the substrate (1) contains silicon carbide.

**18.** Component according to one of Claims 1 to 17, **characterized in that** the substrate (1) contains hexagonal 6H silicon carbide.

**19.** Component according to one of Claims 1 to 18, **characterized in that** the radiation-generating layer (2) contains gallium nitride.

**20.** Component according to one of Claims 1 to 19, **characterized in that** the underside of the substrate has a width (B) of at least 300 μm.

**21.** Method for producing a radiation-emitting semiconductor component according to one of the preceding claims, having the following steps:

- arrangement of a radiation-generating layer (2) on an underside of a radiation-transmissive substrate (1), the refractive index of the substrate (n1) being greater than the refractive index (n2) of the radiation-generating layer (2),
- sawing of V-shaped trenches (14) into the radiation-transmissive substrate (1) by means of a suitably shaped saw, a residual thickness (dr) of the substrate (1) remaining throughout, and inclined side areas (3) being produced,
- singulation of the substrate (1) into a multiplicity of individual substrates (15) along the trenches (14),

wherein, in the region of the residual thickness (dr) of the substrate (1), side areas (5) perpendicular to the underside of the substrate are produced, and

- the radiation-emitting layer (2), after the singulation, covers the underside of the substrate apart from an outer free edge, which has a finite width (bF),
- the difference in refractive index and the finite width of the outer free edge result in an unilluminated substrate region (4), into which no photos are coupled directly from the radiation-generating layer (2) during operation of the radiation-emitting semiconductor component,
- the perpendicular side areas (5) form a base (6) on the underside of the substrate, the inclined side areas (3) adjoining the top side of said base, and
- the upper boundary of the unilluminated region (4) coincides with the upper boundary of the base (6).

**22.** Method according to Claim 21, **characterized in that** the singulation is effected by means of a saw having a straight saw blade.

**23.** Method according to Claim 21, **characterized in that** the singulation is effected by breaking.

**Revendications**

**1.** Composant semiconducteur émettant un rayonnement

- comprenant un substrat (1) transparent au rayonnement sur le côté inférieur duquel est disposée une couche génératrice de rayonnement (2),
- avec lequel le substrat (1) présente des surfaces latérales (3) inclinées,
- avec lequel l'indice de réfraction du substrat (n1) est supérieur à l'indice de réfraction (n2) de la couche génératrice de rayonnement (2),
- avec lequel la couche émettrice de rayonnement recouvre le côté inférieur du substrat à l'exception d'un bord libre extérieur (7) qui présente une largeur finie (bF),
- avec lequel la différence d'indices de réfraction et la largeur finie du bord libre extérieur produisent une zone de substrat non éclairée (4) dans laquelle il n'y a pas d'injection de photons directement depuis la couche génératrice de rayonnement (2),
- avec lequel le substrat (1) présente dans la zone non éclairée (4) des surfaces latérales (5) perpendiculaires au côté inférieur du substrat,
- avec lequel les surfaces latérales (5) perpendiculaires forment sur le côté inférieur du substrat un socle (6) sur le côté supérieur duquel viennent se rejoindre les surfaces latérales (3) inclinées,

**caractérisé en ce que**

- la limite supérieure de la zone non éclairée (4) coïncide avec la limite supérieure (h) du socle (6).

**2.** Composant selon la revendication 1, **caractérisé en ce que** le côté de la couche génératrice de rayonnement (2) à l'opposé du substrat (1) est prévu pour le montage du composant.

3. Composant selon la revendication 2, **caractérisé en ce qu'**une couche de contact électrique réfléchissante (17) est formée sur le côté de la couche génératrice de rayonnement (2) à l'opposé du substrat (1).

4. Composant selon l'une des revendications précédentes, **caractérisé en ce que** la hauteur (h) du socle (6) est comprise entre 15 et 30 μm.

5. Composant selon l'une des revendications 1 à 4, **caractérisé en ce que** les surfaces latérales inclinées (3) forment un angle (α) entre 15 et 40° avec le côté inférieur du substrat.

6. Composant selon l'une des revendications 1 à 5, **caractérisé en ce que** le côté inférieur du substrat (1) présente une largeur (B) entre 300 et 2000 μm.

7. Composant selon l'une des revendications 1 à 6, **caractérisé en ce que** le substrat (1) présente une épaisseur (D) qui est comprise entre 200 et 300 μm.

8. Composant selon l'une des revendications 1 à 7, **caractérisé en ce que** la couche génératrice de rayonnement (2) recouvre le côté inférieur du substrat à l'exception d'un bord libre extérieur (7) ayant une largeur (bF) comprise entre 10 et 50 μm.

9. Composant selon l'une des revendications 1 à 8, **caractérisé en ce que** la couche génératrice de rayonnement (2) présente des bords latéraux biseautés (8) qui réfléchissent la lumière irradiée latéralement par rapport au substrat (1) en direction du substrat (1).

10. Composant selon la revendication 9, **caractérisé en ce que** les bords latéraux biseautés (8) forment avec le côté inférieur du substrat (1) un angle (β) entre 20 et 70°.

11. Composant selon l'une des revendications 9 ou 10, **caractérisé en ce que** les bords biseautés (8) de la couche génératrice de rayonnement (2) forment avec le substrat (1) un angle (β) qui convient pour une réflexion totale du rayonnement sur les bords latéraux (8).

12. Composant selon l'une des revendications 9 à 11, **caractérisé en ce que** les bords latéraux (8) de la couche génératrice de rayonnement (2) sont recouverts d'un matériau (9) optiquement réfléchissant.

13. Composant selon la revendication 12, **caractérisé en ce que** le matériau (9) optiquement réfléchissant est de l'aluminium ou de l'argent.

14. Composant selon l'une des revendications 1 à 13, **caractérisé en ce que**

    - des éléments de contact électriques (10, 10a) sont disposés sur le côté supérieur du substrat (1),
    - la conductivité transversale du substrat (1) donne lieu à un élargissement conique d'un courant injecté par l'élément de contact (10) dans le substrat (1) et
    - les éléments de contact (10) sont espacés les uns des autres de telle sorte que les cônes d'élargissement du courant (13) entrent en contact à une profondeur (T) à laquelle toute la surface de la section transversale du substrat (1) est parcourue par le courant.

15. Composant selon la revendication 14, **caractérisé en ce que** les éléments de contact électriques sont des pistes conductrices (10) qui s'étendent le long de carrés (11) imbriqués les uns dans les autres, les carrés (11) présentant des bords latéraux (12) équidistants parallèles les uns aux autres.

16. Composant selon la revendication 15, **caractérisé en ce que** les pistes conductrices (10) présentent des largeurs (bL1, bL2, bL3) différentes les unes des autres en correspondance avec la surface du substrat (1) à alimenter en courant.

17. Composant selon l'une des revendications 1 à 16, **caractérisé en ce que** le substrat (1) contient du carbure de silicium.

18. Composant selon l'une des revendications 1 à 17, **caractérisé en ce que** le substrat (1) contient du carbure de silicium 6H hexagonal.

19. Composant selon l'une des revendications 1 à 18, **caractérisé en ce que** la couche génératrice de rayonnement (2) contient du nitrure de gallium.

20. Composant selon l'une des revendications 1 à 19, **caractérisé en ce que** le côté inférieur du substrat présente une largeur (B) d'au moins 300 μm.

21. Procédé de fabrication d'un composant semiconducteur émettant un rayonnement selon l'une des revendications précédentes, comprenant les étapes suivantes :

    - disposition d'une couche génératrice de rayonnement (2) sur le côté inférieur d'un substrat (1) transparent au rayonnement, l'indice de réfraction du substrat (n1) étant supérieur à l'indice de réfraction (n2) de la couche génératrice de rayonnement (2),

- façonnage de fossés en forme de V (14) dans le substrat (1) transparent au rayonnement au moyen d'une scie de forme appropriée, l'épaisseur restante (dr) du substrat (1) restant continuellement maintenue et des surfaces latérales inclinées (3) étant produites,

- division du substrat (1) en une pluralité de substrats individuels (15) le long des fossés (14), des surfaces latérales (5) perpendiculaires au côté inférieur du substrat étant produites dans la zone de l'épaisseur restante (dr) du substrat (1) et

- la couche génératrice de rayonnement (2), après la division, recouvrant le côté inférieur du substrat à l'exception d'un bord libre extérieur qui présente une largeur finie (bF),

- la différence d'indices de réfraction et la largeur finie du bord libre extérieur produisant une zone de substrat non éclairée (4) dans laquelle il n'y a pas d'injection de photons directement depuis la couche génératrice de rayonnement (2) lors du fonctionnement du composant semiconducteur émettant un rayonnement,

- les surfaces latérales (5) perpendiculaires formant sur le côté inférieur du substrat un socle (6) sur le côté supérieur duquel viennent se rejoindre les surfaces latérales (3) inclinées, et

- la limite supérieure de la zone non éclairée (4) coïncidant avec la limite supérieure (h) du socle (6).

**22.** Procédé selon la revendication 21, **caractérisé en ce que** la division est réalisée avec une scie munie d'une lame droite.

**23.** Procédé selon la revendication 21, **caractérisé en ce que** la division est réalisée par rupture.

## FIG 1

## FIG 2

FIG 3

FIG 4

# FIG 5

bL3

bL2

bL1

16

10a

10

10

12

12

12

11

10

11

10a

11

11

bQ1

bQ2

bQ3

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5087949 A
- US 5187547 A

- WO 0161764 A